# FASCICULE DE BREVET EUROPEEN

(11) **EP 1 464 993 B1**
(45) Date de publication et mention de la délivrance du brevet: **05.10.2005**
(21) Numéro de dépôt: 04354013.7
(22) Date de dépôt: 16.03.2004
(51) Int. Cl.: G02B 1/10, H01L 21/033, G02B 5/08, G21K 1/06

(54) **Dispositif optique à stabilité mécanique renforcée fonctionnant dans l'extrême ultraviolet et masque de lithographie comportant un tel dispositif**
EUV optische Vorrichtung mit verstärkter mechanischer Stabilität und lithographische Maske mit dieser Vorrichtung
Optical device with improved mechanical stability for the extreme ultraviolet and lithography mask incorporating the device

(30) Priorité: 01.04.2003 FR 0304071
(43) Date de publication de la demande: 06.10.2004
(73) Titulaire: COMMISSARIAT A L'ENERGIE ATOMIQUE, 75752 Paris Cédex 15 (FR)
(72) Inventeur: Quesnel, Etienne, 38240 Meylan (FR)
(74) Mandataire: Hecké, Gérard

(56) Documents cités:
- US-A- 5 310 603
- US-B1- 6 396 900
- DRÜSEDAU T P ET AL: "The hydrogenated amorphous silicon/nanodisperse metal (SIMAL) system - Films of unique electronic properties" JOURNAL OF NON-CRYSTALLINE SOLIDS, NORTH-HOLLAND PUBLISHING COMPANY, AMSTERDAM, NL, vol. 198-200, mai 1996 (1996-05), pages 829-832, XP004243138 ISSN: 0022-3093
- WINDT D L ET AL: "Variation in stress with background pressure in sputtered Mo/Si multilayer films" JOURNAL OF APPLIED PHYSICS, 15 AUG. 1995, USA, vol. 78, no. 4, pages 2423-2430, XP002280663 ISSN: 0021-8979
- KIM D S ET AL: "Annealing effects on a-SiC:H and a-SiC:H(F) thin films deposited by PECVD at room temperature" PREPARATION AND CHARACTERIZATION, ELSEVIER SEQUOIA, NL, vol. 261, no. 1-2, 1 juin 1995 (1995-06-01), pages 192-201, XP004314183 ISSN: 0040-6090

## Description

### Domaine technique de l'invention

L'invention concerne un dispositif optique réfléchissant une gamme de longueurs d'ondes comprise entre 10nm et 20nm et comportant une alternance de premières et secondes couches superposées, lesdites premières couches étant en métal ou en composé métallique et lesdites secondes couches comportant du silicium amorphe.

L'invention concerne également un masque de lithographie comportant un tel dispositif optique.

### État de la technique

Les dispositifs optiques destinés à réfléchir une gamme de longueurs d'onde comprise dans l'extrême ultraviolet (EUV), c'est-à-dire entre 10nm et 20nm, sont généralement composés de plusieurs couches alternées de molybdène et de silicium. Ainsi, l'article "The hydrogenated amorphous silicon / nanodisperse metal (SIMAL) system - Films of unique electronic properties" (T.P. Drüsedau et al, Journal of Non Crystalline Solids 198-200 (1996), pages 829-832) mentionne que des système multicouches comportant du silicium amorphe ou du silicium amorphe hydrogéné et des métaux sont utilisés comme miroirs dans le domaine des rayons X mous.

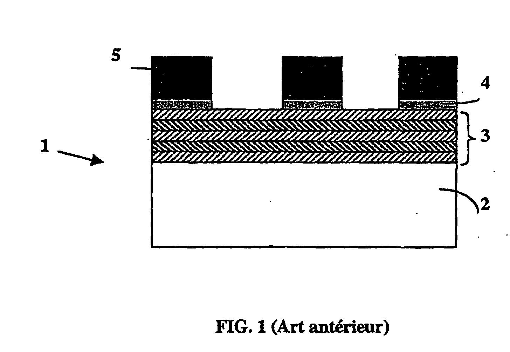

Les masques de lithographie 1 utilisés en EUV comportent généralement un substrat 2 recouvert d'un réflecteur 3 composé de plusieurs couches alternées (aussi appelé empilement multicouches), de préférence en silicium amorphe et en molybdène, et d'une couche de protection et sur lequel est déposée une couche tampon 4 en silice et une couche absorbante 5 (figure 1).

Le couple Mo/Si permet d'obtenir une réflexion maximale théorique de 74% pour une longueur d'onde de 13,4 nm. Il est, cependant, difficile d'atteindre cette valeur maximale théorique, notamment à cause d'un phénomène d'interdiffusion ayant lieu entre le silicium et le molybdène. Ainsi, à la place d'un système périodique de deux couches superposées en molybdène et en silicium (Mo/Si), il se crée, dans le dispositif optique, un système périodique de 4 couches de Mo/MoSiₓ/Si/SiMo_{y,}, MoSiₓ et SiMo_{y} correspondant à une partie des couches de molybdène et de silicium dans lesquelles se diffusent respectivement du silicium et du molybdène. Un tel système périodique a une réflectivité moins stable thermiquement que le système périodique théorique Mo/Si.

Or, un dispositif optique tel qu'un réflecteur de masque de lithographie utilisé en EUV, doit avoir des contraintes mécaniques faibles et des propriétés mécaniques et optiques stables dans le temps, notamment lorsque le dispositif optique est soumis à des sollicitations thermiques ou environnementales. En effet, un masque de lithographie destiné à subir une série d'opérations susceptibles d'exposer le réflecteur à des conditions de températures proches de 200°C, doit conserver des propriétés mécaniques et optiques stables tout au long de sa durée d'utilisation.

Des variantes au couple Mo/Si ont, ainsi, été proposées pour rendre les propriétés optiques stables. Ainsi, il est possible d'utiliser un système périodique de quatre couches, une couche de carbure de molybdène, de carbure de bore ou de carbone étant interposée entre les couches de molybdène et de silicium, de manière à obtenir, respectivement les systèmes périodiques suivants : Mo/Mo₂C/Si/Mo₂C, Mo/B₄C/Si/B₄C ou Mo/C/Si/C. Le système périodique Mo/B₄C/Si/B₄C est, par exemple, illustré dans le brevet US6396900. Il est, également, possible d'utiliser un système périodique de deux couches en remplaçant le molybdène par du carbure de molybdène, de manière à obtenir le système périodique Mo₂C/Si.

Ainsi, T.Feigl et al., dans l'article « Magnetron sputtered EUV mirrors with high thermal stability » (Emerging Lithographic Technologies IV, Elisabeth A. Dobisz, Editor, Proceedings of SPIE, vol 3997 (2000), pages 420 à 430), indiquent que la réflectivité des empilements multicouches de type Mo/Si décroît fortement à la suite de recuits réalisés au-dessus de 300°C tandis que les empilements multicouches de type Mo₂C/Si ont une réflectivité stable thermiquement jusqu'à 600°C. Même si ces solutions permettent d'améliorer les propriétés optiques du dispositif et de les rendre stables thermiquement, les propriétés mécaniques de tels empilements multicouches diminuent de plusieurs dizaines de MPa avec la température.

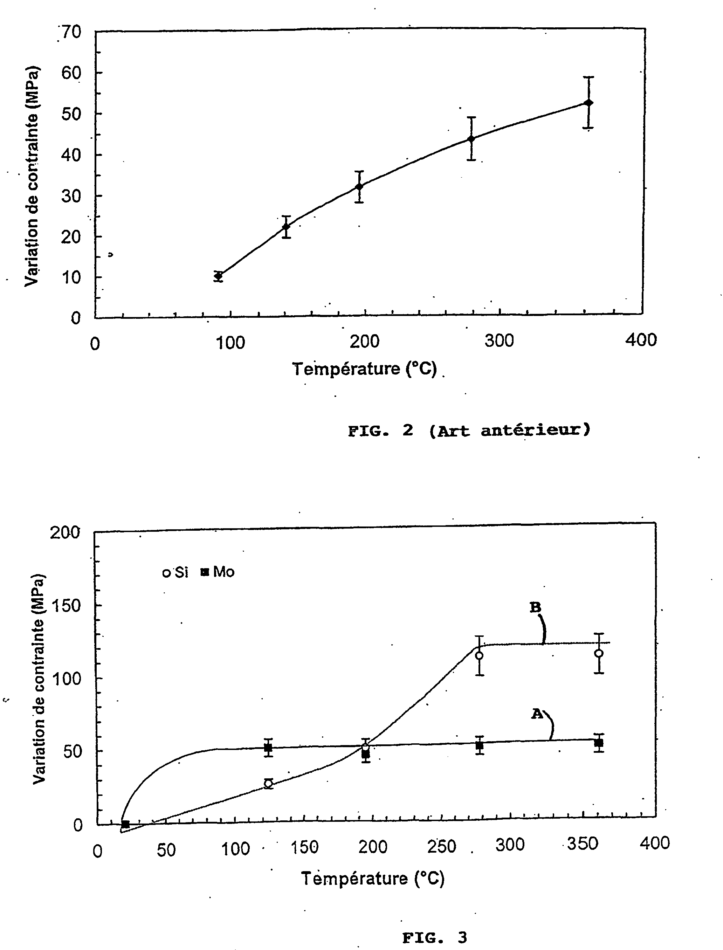

Le niveau de contraintes mécaniques du couple Mo/Si est relativement élevé. Ainsi, dans un miroir comportant une alternance de 40 premières couches en molybdène et 40 secondes couches en silicium amorphe, les contraintes mécaniques initiales du miroir sont de -400MPa. La figure 2 représentant les effets de recuits cumulés réalisés pendant 16 heures et sous vide, sur un tel miroir, indique également que les contraintes mécaniques varient fortement en fonction de la température. Or, pour un masque de lithographie utilisé en EUV par exemple, la déformation maximale autorisée est de 50nm, ce qui n'est pas compatible avec une telle variation de contraintes mécaniques, celles-ci conditionnant fortement la planéité du front d'onde optique du masque de lithographie.

Il a été proposé, dans le document WO99/42414, d'utiliser l'instabilité thermique des contraintes mécaniques du couple Mo/Si pour diminuer le niveau de contraintes dans les systèmes multicouches en réalisant des recuits entre 100°C et 300°C. Cette méthode n'est, cependant, pas reproductible.

### Objet de l'invention

L'invention a pour but un dispositif optique dont les contraintes mécaniques sont stables par rapport à une variation de température, tout en conservant une réflexion optique maximale.

Selon l'invention, ce but est atteint par les revendications annexées.

Plus particulièrement, ce but est atteint par le fait que les secondes couches sont constituées par un composé de silicium amorphe choisi parmi a-Si-Hₓ, a-Si-CHₓ, a-Si-Cₓ, a-Si-OHₓ, a-Si-Fₓ, a-Si-FHₓ, a-Si-Nₓ, a-Si-NHₓ, x étant compris entre 0,01 et 0,3.

Selon un mode de réalisation préférentiel, chaque première couche est constituée d'une couche intermédiaire en métal, disposée entre deux couches périphériques.

Selon une autre caractéristique de l'invention, le métal est le molybdène.

L'invention a également pour but un masque de lithographie à contraintes mécaniques stables dans le temps.

Selon l'invention, ce but est atteint par le fait que le masque de lithographie comporte un dispositif optique tel que décrit ci-dessus.

Selon un développement de l'invention, l'épaisseur d'un ensemble formé par une première et une seconde couches superposées est de 6,9 nm.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 est une représentation schématique d'un masque de lithographie selon l'art antérieur.
La figure 2 est un graphique représentant une variation des contraintes mécaniques en fonction de la température pour un réflecteur selon l'art antérieur.
La figure 3 est un graphique représentant une variation des contraintes mécaniques en fonction de la température pour une couche en molybdène et pour une couche en silicium.
La figure 4 est un graphique représentant une variation des contraintes mécaniques en fonction du temps de recuits pour une couche en a-Si et pour une couche en a-Si-Hₓ.
La figure 5 est un graphique représentant une variation des réponses optiques de deux miroirs, respectivement selon l'art antérieur et selon l'invention, en fonction de la longueur d'onde.

### Description de modes particuliers de réalisation.

Un dispositif optique réfléchissant une gamme de longueurs d'ondes comprise entre 10nm et 20nm comporte une alternance de premières et secondes couches superposées. Les premières couches sont en métal et, de préférence, en molybdène ou en composé métallique et, de préférence, en carbure de molybdène. Les secondes couches sont constituées par un composé de silicium amorphe choisi parmi a-Si-Hₓ, a-Si-CHₓ, a-Si-Cₓ, a-Si-OHₓ, a-Si-Fₓ, a-Si-FHₓ, a-Si-Nₓ et a-Si-NHₓ, x étant compris entre 0,01 et 0,3. Ainsi, un radical choisi parmi -H, -CH, -C, -OH, -F, -FH, -N et -NH est incorporé au silicium amorphe, de manière à saturer les liaisons pendantes dans le silicium amorphe. A titre d'exemple, par composé a-Si-Hₓ, on entend un composé constitué de silicium amorphe hydrogéné, c'est-à-dire du silicium amorphe dans lequel est incorporé un taux prédéterminé d'hydrogène. Le taux d'hydrogène à incorporer se situe dans la gamme de 1 à 25 % d'hydrogène atomique lié.

L'utilisation des secondes couches en composé de silicium amorphe permet de stabiliser thermiquement les contraintes mécaniques du dispositif optique. En effet, il est connu que les contraintes mécaniques d'un empilement multicouches en molybdène et en silicium amorphe (Mo/a-Si) évoluent fortement lorsque l'empilement subit un recuit pendant plusieurs heures (figure 2). Cette évolution dépend notamment de l'environnement. Ainsi, pour des recuits de deux heures réalisés sous une atmosphère d'azote, la variation des contraintes mécaniques est de l'ordre de quelques centaines de MPa tandis que la variation des contraintes mécaniques est de l'ordre de quelques dizaines de MPa, pour des recuits de deux heures réalisés sous vide. Une variation de contraintes de quelques dizaines de MPa reste, cependant, trop élevée pour des applications optiques telles que les masques de lithographie.

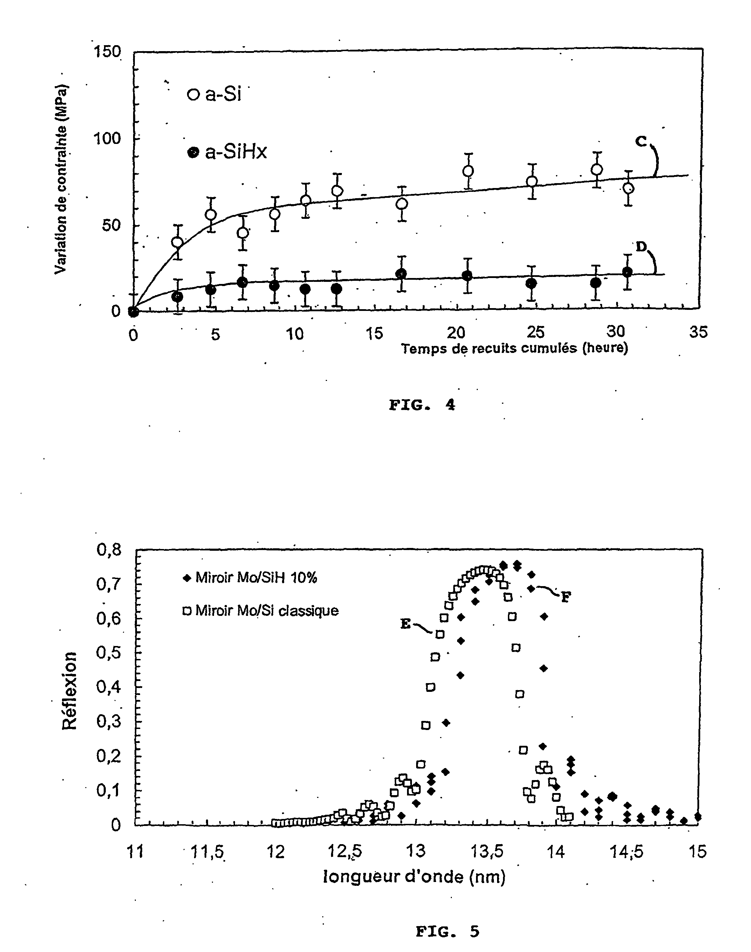

Lorsqu'une couche de molybdène d'une épaisseur de 100nm et une couche de silicium amorphe d'une épaisseur de 100nm subissent respectivement des recuits réalisés sous vide pendant 16 heures (figure 3), le comportement des contraintes mécaniques en fonction de la température diffère fortement dans la couche en molybdène (courbe A) et dans la couche de silicium amorphe (Courbe B). Ainsi, les contraintes mécaniques de la couche de Mo, initialement de -2500MPa, augmentent jusqu'à 80°C puis se stabilisent, tandis que les contraintes mécaniques de la couche de a-Si augmentent fortement avec la température. Ainsi, le taux de variation de contraintes mécaniques est de l'ordre de 2% pour la couche en Mo et de l'ordre 10% pour la couche en a-Si. L'évolution des contraintes mécaniques dans les empilements multicouches à base de Mo et Si est probablement due à l'instabilité du silicium.

Ainsi, selon l'invention, la saturation des liaisons pendantes dans le silicium amorphe par les radicaux -H, -CH, -C, -OH, -F, -FH, -N, -NH permet d'éviter la relaxation des contraintes mécaniques due au fluage de la matrice de silicium. En effet, une couche en a-Si-Hₓ présente des contraintes mécaniques initiales très proches de celle d'une couche en silicium amorphe, c'est-à-dire proche de -950 MPa. Par contre, le comportement en vieillissement mécanique d'une couche de silicium hydrogéné est différent de celui d'une couche de silicium amorphe.

Ainsi, la figure 4 illustre la différence de comportement des contraintes mécaniques pour une couche en a-Si (Courbe C) et pour une couche en a-Si-Hₓ (Courbe D), lorsqu'elles subissent respectivement des recuits cumulés à 195°C. Chaque couche a une épaisseur de 100nm et la couche en a-Si-Hₓ est réalisée par un dépôt de type IBS (« Ion Beam Sputtering ») en pulvérisant une cible de silicium, avec un gaz de pulvérisation composé d'argon et de 5 % en volume d'hydrogène. Le dépôt du silicium hydrogéné peut également être réalisé en pulvérisant la cible de silicium dans une atmosphère réactive d'hydrogène. Pour la couche en silicium amorphe, les recuits entraînent une forte variation des contraintes mécaniques pendant les premières heures de recuits (jusqu'à 7 heures) mais également une variation progressive tout au long de la durée des recuits cumulés. Par contre, pour la couche en silicium amorphe hydrogéné, les recuits entraînent une faible variation des contraintes mécaniques jusqu'à environ 5 heures de recuits, puis les contraintes mécaniques se stabilisent. Ainsi, la variation relative des contraintes mécaniques dans la couche en silicium amorphe est de l'ordre de 5 % à 6 %, tandis que cette variation est de l'ordre de 1 % pour la couche en a-Si-Hₓ, L'incorporation d'une proportion prédéterminée d'hydrogène ou d'un radical choisi parmi -CH, -C, -OH, -F, -FH, -N, -NH, dans le silicium amorphe permet de le rendre insensible aux recuits.

L'utilisation d'un composé de silicium amorphe permet, donc, non seulement de stabiliser les contraintes mécaniques dans un dispositif optique comportant un empilement de couches jusqu'à au moins 200°C, mais aussi de conserver de bonnes propriétés optiques. Ainsi, la figure 5 représente une simulation théorique des réponses optiques de deux miroirs comportant chacun un empilement multicouches. La courbe E correspond à un empilement de 40 couches de molybdène alternées avec 40 couches de silicium amorphe, tandis que la courbe F correspond à un empilement de 40 couches de molybdène alternées avec 40 couches de silicium amorphe hydrogéné a-Si-H_{0,1}. Les épaisseurs des couches en molybdène et en silicium amorphe hydrogéné sont respectivement de 4,1 nm et 2,8nm. Le miroir comportant l'empilement Mo/a-Si-H_{0,1} présente une réflectivité équivalente à celle d'un miroir comportant un empilement Mo/Si. Ainsi, l'ajout d'hydrogène ne détériore pas les propriétés optiques du miroir. Les couches de molybdène du miroir selon la courbe F ont été réalisées par pulvérisation d'une cible de molybdène par de l'argon ou du xénon tandis que les couches en a-Si-H_{0,1} ont été réalisées en pulvérisant du silicium sous une atmosphère réactive en hydrogène.

Selon l'invention, les premières couches du dispositif optique peuvent, également, être constituées par un composé métallique tel qu'un carbure de molybdène Mo₂C ou un nitrure de métal. Ceci présente l'avantage, pour un miroir comportant un empilement alterné de 40 couches en Mo₂C et 40 couches en a-Si-Hₓ de conserver des contraintes mécaniques stables sur un domaine de température plus élevé et, de préférence, jusqu'à 350°C.

Chaque première couche du dispositif optique peut, également, être constituée par une couche intermédiaire en métal, disposée entre deux couches périphériques. Les couches périphériques peuvent être en carbure dudit métal, et, de préférence, en carbure de molybdène. Les couches périphériques peuvent également être en carbure de bore, en carbone ou en nitrure dudit métal. Ainsi, selon l'invention, un empilement constitué par une alternance de premières et secondes couches peut être du type MY/M/MY/a-Si-Hₓ, B₄C/M/B₄C/a-Si-Hₓ ou C/M/C/a-Si-Hₓ, M étant un métal, MY étant un composé métallique tel qu'un carbure ou un nitrure dudit métal et C étant le carbone. Ainsi, à titre d'exemple, on remplace la couche en Mo₂C par trois couches superposées, respectivement en Mo₂C, Mo et Mo₂C, l'ensemble ayant une épaisseur totale de 2,8nm. Ceci présente l'avantage d'améliorer la réflectivité optique par rapport à un empilement Mo₂C/a-Si-Hₓ, tout en conservant une stabilité mécanique sur un domaine de température allant jusqu'à 350°C. Un résultat similaire est obtenu lorsqu'on remplace la couche en Mo₂C par trois couches superposées, respectivement en B₄C, Mo et B₄C.

Les premières et secondes couches de l'empilement peuvent être réalisées par tout type de procédé connu pour la réalisation de couches minces. Ainsi, elles peuvent être réalisées par des dépôts physiques en phase vapeur ou PVD (« Physical Vapour Deposition ») ou par des dépôts chimiques en phase vapeur ou CVD (« Chemical Vapour Deposition »).

Un dispositif optique selon l'utilisation permet, notamment de réaliser un réflecteur pour masque de lithographie utilisé en EUV, tel que celui représenté à la figure 1. Le réflecteur multicouche est, de préférence, composé d'une alternance de 40 à 60 premières couches en molybdène ou en carbure de molybdène et de 40 à 60 secondes couches constituées par un composé de silicium amorphe choisi parmi a-Si-Hₓ, a-Si-CHₓ, a-Si-Cₓ, a-Si-OHₓ, a-Si-Fₓ, a-Si-FHₓ, a-Si-Nₓ, a-Si-NHₓ, x étant compris entre 0,01 et 0,3. L'épaisseur d'un ensemble formé par une première et une seconde couches superposées définit la période de l'empilement et la longueur d'onde de centrage du réflecteur pour laquelle la réflectivité est maximale. Elle est, de préférence, de 6,9nm pour un angle d'incidence proche de la normale et lorsque le réflecteur fonctionne à une longueur d'onde de 13,4nm. Un tel masque de lithographie présente l'avantage d'avoir non seulement de bonnes propriétés optiques, mais aussi des contraintes mécaniques stabilisées jusqu'à au moins 200°C. Ceci permet de réaliser des masques de lithographie dont la déformation est contrôlée au cours de leur utilisation. Le dispositif optique selon l'invention peut également être utilisé pour réaliser des fonctions optiques de type miroir, antireflet ou filtrage.

## Revendications

1. Dispositif optique réfléchissant une gamme de longueurs d'ondes comprise entre 10nm et 20nm et comportant une alternance de premières et secondes couches superposées, lesdites premières couches étant en métal ou en composé métallique et lesdites secondes couches comportant du silicium amorphe, dispositif optique **caractérisé en ce que** les secondes couches sont constituées par un composé de silicium amorphe choisi parmi a-Si-Hₓ, a-Si-CHₓ, a-Si-C_{x,} a-Si-OHₓ, a-Si-Fₓ, a-Si-FHₓ, a-Si-Nₓ, a-Si-NHₓ, x étant compris entre 0,01 et 0,3.

2. Dispositif optique selon la revendication 1, **caractérisé en ce que** chaque première couche est constituée d'une couche intermédiaire en métal, disposée entre deux couches périphériques.

3. Dispositif optique selon la revendication 2, **caractérisé en ce que** les deux couches périphériques sont en carbure dudit métal, en nitrure dudit métal, en carbure de bore ou en carbone.

4. Dispositif optique selon l'une quelconque des revendications 1 à 3, **caractérisé en ce que** le métal est le molybdène.

5. Dispositif optique selon l'une quelconque des revendications 1 à 4, **caractérisé en ce que** le composé métallique est un carbure de molybdène.

6. Masque de lithographie comportant un dispositif optique selon l'une quelconque des revendications 1 à 5.

7. Masque de lithographie selon la revendication 6, **caractérisé en ce que** l'épaisseur d'un ensemble formé par une première et une seconde couches superposées est de 6,9 nm.

8. Masque de lithographie selon l'une des revendications 6 et 7, **caractérisé en ce que** le nombre de premières couches est compris entre 40 et 60.

## Patentansprüche

1. Optische Vorrichtung, die einen Bereich von Wellenlängen reflektiert, der von 10 bis 20 nm reicht, und die eine Wechselfolge erster und zweiter übereinander gelagerter Schichten umfasst, welche ersten Schichten aus Metall oder einer Metallverbindung bestehen und welche zweiten Schichten amorphes Silizium umfassen, eine optische Vorrichtung, die **dadurch gekennzeichnet ist, dass** die zweiten Schichten aus einer Verbindung aus amorphem Silizium bestehen, die aus der aus a-Si-Hₓ, a-Si-CHₓ, a-Si-Cₓ, a-Si-OHₓ, a-Si-Fₓ, a-Si-FHₓ, a-Si-Nₓ, a-Si-NHₓ gebildeten Gruppe ausgewählt ist, wobei x einen Wert von 0,01 bis 0,3 darstellt.

2. Optische Vorrichtung nach Anspruch 1, **dadurch gekennzeichnet, dass** jede erste Schicht aus einer Zwischenschicht aus Metall besteht, die zwischen zwei Randschichten angeordnet ist.

3. Optische Vorrichtung nach Anspruch 2, **dadurch gekennzeichnet, dass** die beiden Randschichten aus einem Karbid oder einem Nitrid des genannten Metalls oder aus Borkarbid oder Kohlenstoff bestehen.

4. Optische Vorrichtung nach einem der Ansprüche 1 bis 3, **dadurch gekennzeichnet, dass** das Metall Molybdän ist.

5. Optische Vorrichtung nach einem der Ansprüche 1 bis 4, **dadurch gekennzeichnet, dass** die Metallverbindung ein Molybdänkarbid ist.

6. Lithografiemaske, die eine optische Vorrichtung nach einem der Ansprüche 1 bis 5 umfasst.

7. Lithografiemaske nach Anspruch 6, **dadurch gekennzeichnet, dass** die Dicke einer aus einer ersten und einer zweiten übereinander gelagerten Schicht gebildeten Einheit 6,9 nm beträgt.

8. Lithografiemaske nach einem der Ansprüche 6 und 7, **dadurch gekennzeichnet, dass** die Anzahl erster Schichten 40 bis 60 beträgt.

## Claims

1. Optical device reflecting a range of wavelengths comprised between 10nm and 20nm and comprising alternate superposed first and second layers, said first layers being made of metal or metallic compound and said second layers comprising amorphous silicon, optical device **characterized in that** the second layers are formed by an amorphous silicon compound chosen from a-Si-Hₓ, a-Si-CHₓ, a-Si-Cₓ, a-Si-OHₓ, a-Si-Fₓ, a-Si-FHₓ, a-Si-Nₓ, a-Si-NHₓ, x being comprised between 0.01 and 0.3.

2. Optical device according to claim 1, **characterized in that** each first layer is formed by an intermediate metal layer, arranged between two peripheral layers.

3. Optical device according to claim 2, **characterized in that** the two peripheral layers are made of carbide of said metal, nitride of said metal, boron carbide or carbon.

4. Optical device according to any one of claims 1 to 3, **characterized in that** the metal is molybdenum.

5. Optical device according to any one of claims 1 to 4, **characterized in that** the metallic compound is a molybdenum carbide.

6. Lithography mask comprising an optical device according to any one of the claims 1 to 5.

7. Lithography mask according to claim 6, **characterized in that** the thickness of the assembly formed by a first layer and a second layer which are superposed is 6.9nm.

8. Lithography mask according to claims 6 or 7, **characterized in that** the number of first layers is comprised between 40 and 60.
